Europäisches Patentamt

European Patent Office

Office européen des brevets

(19)

(11) Publication number: **0 058 571**

**A1**

(12) **EUROPEAN PATENT APPLICATION**

(21) Application number: **82300807.3**

(22) Date of filing: **17.02.82**

(51) Int. Cl.³: **C 23 C 11/00**
**C 03 B 37/025**

(30) Priority: **18.02.81 GB 8105035**

(43) Date of publication of application:
**25.08.82 Bulletin 82/34**

(84) Designated Contracting States:
**DE SE**

(71) Applicant: **NATIONAL RESEARCH DEVELOPMENT CORPORATION**
**P.O. Box 236 Kingsgate House 66-74 Victoria Street**
**London SW1E 6SL(GB)**

(72) Inventor: **Payne, David Neil**
**15 Crabwood Close Maybush**
**Southampton Hampshire(GB)**

(72) Inventor: **Tarbox, Eleanor Joan**
**32 Highfield Road**
**Highfield Southampton Hampshire(GB)**

(74) Representative: **Percy, Richard Keith**
**National Research Development Corporation Patent**
**Department P.O. Box 236 Kingsgate House 66/74**
**Victoria Street**
**London SW1E 6SL(GB)**

(54) **Method and apparatus for delivering a controlled flow rate of reactant to a vapour deposition process.**

(57) In a vapour phase deposition reaction, particularly the oxidation of a silicon tetrahalide to silica concomitantly with the oxidation of small quantities of other halides to serve as dopants, there have been problems in providing a controlled rate of flow of vapour to the reaction zone. A flow rate which can be varied in a controlled manner, as required from time to time, is critical for various purposes, particularly the production of optical fibres. The invention is based on the finding that a high degree of accuracy of control can be achieved by metering liquid reactant, evaporating it and feeding the vapour to the reaction zone. Alternatively, if desired the liquid can be fed directly into the reaction zone in a finely dispersed form and allowed to vaporise therein. The flow rate of the liquid reactant is controlled independently of the flow rate of carrier gas. The invention is particularly useful in making optical fibres or silica-based semi-conductor devices.

Apparatus preferred for use in the invention includes a flow controller, e.g. comprising a stepper motor (85) connected to a carriage (83) operating a displacement pump or equivalent (81 or 82,) a vaporiser (102), having inlets (92, 91) for reactant liquid and carrier gas, and a manifold (94) where the vapour and carrier gas mix. The mixture is introduced through an outlet (95) from the manifold into a vapour deposition reaction zone (11).

Fig. 8

- 1 -

121179

METHOD AND APPARATUS FOR DELIVERING A CONTROLLED FLOW
RATE OF REACTANT TO A VAPOUR DEPOSITION PROCESS

1.    Introduction

This invention is in the field of apparatus for delivering reactants to a chemical reaction in which a solid deposit is formed from the vapour phase (referred to herein as a vapour deposition process).

Most processes for making high-silica optical fibres use a vapour phase deposition reaction whereby silica doped with a component such as boric oxide, germania, phosphorus pentoxide or titania is deposited by oxidation of the volatile halides. In addition, fluorine may be used as a dopant, e.g. by deposition from sulphur hexafluroide or other liquid fluorine-containing compound. Each method, therefore, requires the production of stable, reproducible flows of halide vapours which are subsequently oxidised to form the glass. Typical liquid consumption figures are: $SiCl_4$ 0.5 to 2.0 ml $min^{-1}$; $GeCl_4$, $BBr_3$ and $POCl_3$ 0.01 to 1.0 ml $min^{-1}$. The flow rate must be very stable, the maximum permitted variation being only 1%, in order to produce a glass preform having a well-controlled refractive index profile. For a multi-mode graded-index fibre preform, the refractive index should increase smoothly in the radial direction. That is, the concentration of dopant must increase in a smooth gradient from the periphery to the centre of the fibre.

Very stable flows are similarly required in the semi-conductor industry where vapour-phase epitaxy is used for the growth of silica substrates and silicon tetrachloride is a common starting material. Also, in the doping of silicon slices with boron or phosphorus, controlled delivery of halide vapours is necessary.

In order to explain the background to the invention, we review prior vapour deposition processes for optical fibre production, with reference to Figures 1 - 4 of the accompanying drawings.

In the accompanying drawings:-

Figure 1 is a schematic view of three stages, (a), (b) and (c), of a prior process of making an optical fibre. The views are a schematic axial section of the three stages plus transverse sections corresponding to stages (a) and (b).

Figures 2 and 3 are schematic views of two prior vapour phase deposition reactions, Figure 2 in side elevation, Figure 3 in perspective.

Figure 4 is a diagrammatic view of a prior method of delivering reactants to a deposition zone for the vapour phase deposition process.

Figures 5 to 9 refer to the present invention and are described in more detail hereinafter.

## 1.1 Modified Chemical-Vapour Deposition (MCVD) Process

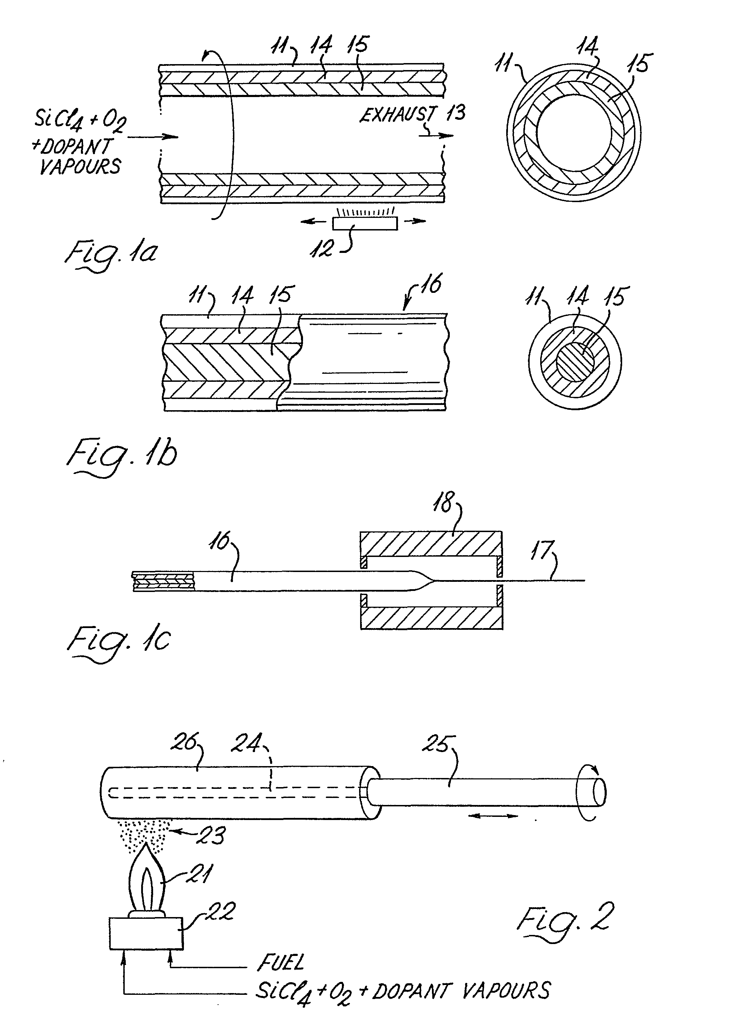

The MCVD process has been described by J.B. MacChesney, P.B. O'Connor, F.V. Di Marcello, J.R. Simpson and P.D. Lazay, Proc. Xth Int. Glass Congress, No. 6, 40-45 (1974). As shown in Figure 1, stage (a) halide vapours and oxygen gas are fed into a silica tube, 11. Tube 11 is a chemically-cleaned tube (typically 20 mm. x 17 mm. x 100 cm) of fused silica mounted for rotation in a glass-working lathe (not shown). An oxy-gas torch 12 is mounted externally to the tube for reciprocal movement along the length of the tube. The tube is rotated, as indicated schematically by the arrowed ring, while being heated by the oxy-gas torch. The torch moves at a slow speed (typically 0.3 cm.s$^{-1}$) heating the tube to approximately 1650$^{\circ}$C. Having traversed the length of the tube, it returns at a faster speed and lower flame temperature, to complete one heating cycle. Throughout the torch cycle, controlled constant proportions of fibre-optic grades of boron, germanium and phosphoryl halides plus silicon tetrachloride are passed through the tube in an oxygen carrier gas. The deposition and simultaneous fusion of a thin layer about 10 microns thick of glass occurs along the internal surface of the tube traversed by the torch. Gases and some undeposited oxides are exhausted at the far end 13 of the tube.

Typically, a borosilicate cladding layer 14 is first deposited and then a phospho-germanosilicate core 15. For a core of graded refractive index, the flow rate of germanium tetrachloride is increased by small increments to provide a composition gradient in the core and thus a graded refractive index profile in the fibre, W.G. French, G.W. Tasker and J.R. Simpson, Applied Optics, 15 (7) 1803 (1976). When sufficient layers have been deposited, the fused silica tube shown in stage (a) is collapsed into a solid rod 16, shown in stage (b) by slowing down the traverse speed of the torch and increasing the temperature of the tube to about 1900°C. During the collapse of the tube, the flow of reactants is stopped and only a small flow of oxygen maintained. Alternatively, a small flow of dopant reactant only is introduced to compensate for the evaporation at high temperature of dopant from the deposit. The resulting solid rod, or preform, 16, is subsequently drawn into a fibre 17, several kilometres long in a high-purity graphite furnace, 18, see stage (c).

### 1.2 Plasma-activated Chemical-Vapour Deposition (PCVD) Process

The PCVD process, D. Kuppers, J. Koenings and H. Wilson, J. Electrochem. Soc., 123, 1079 (1976), is similar to the MCVD process except that the isothermal reaction zone is replaced by a non-isothermal microwave-activated zone and, instead of atmospheric conditions, low internal tube pressures in the region 1-100 torr are typically applied. A larger number of layers per unit time may be deposited using this technique, since the deposition takes place instantaneously upon exposure of the gas mixture to the plasma. The reaction and deposition zone may therefore be moved at high speed along the length of the tube. Owing to the larger number of thin layers, the refractive index profile more closely approximates the ideal smooth form. Another advantage is that the halide vapours are converted to oxides with an efficiency of nearly 100%, compared with about 60% in the MCVD process.

### 1.3 The Outside Vapour-Phase Oxidation (OVPO) Process

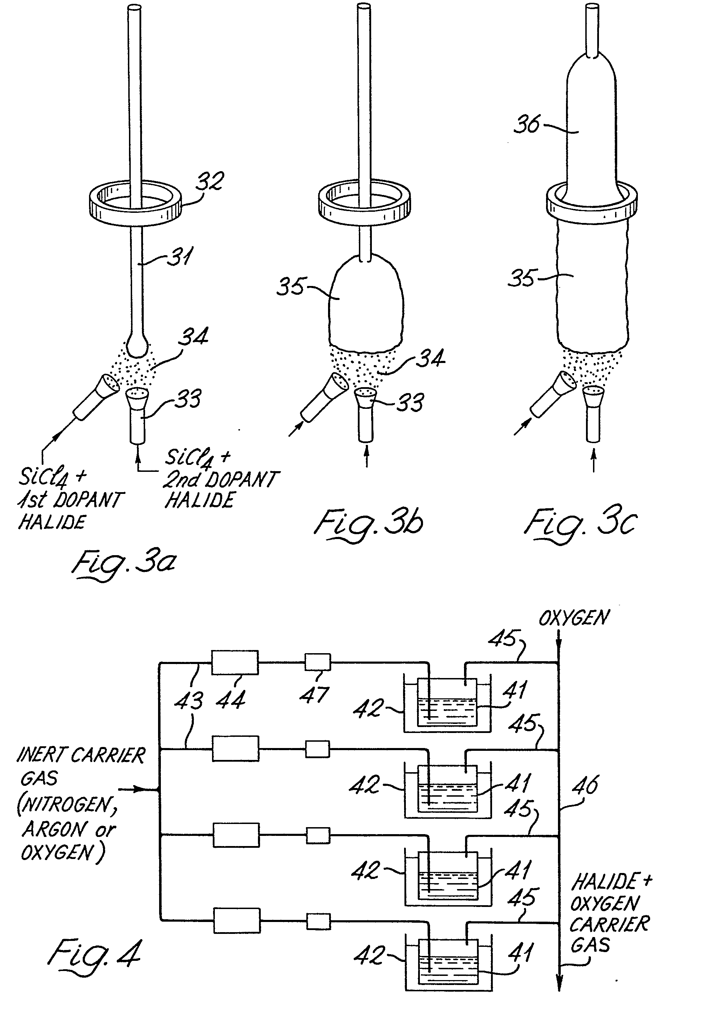

The OVPO process, see U.K. Patent Specification No. 2003132A (Corning), is illustrated by Figure 2. Halide vapours and oxygen are fed into the flame 21 of a combustion burner 22, the oxide particles 23 thus produced are sprayed onto a mandrel 24, having a handle 25. The handle is rotated, as indicated by the arrowed ring and moved axially, relative to the flame-spray. The oxides deposited on mandrel 24 form a porous preform 26. The refractive index of the glass is controlled by adjusting the dopant halide vapour concentrations in the flame. The porous preform 26 is consolidated and dried in a furnace before being drawn into fibre (these steps are not illustrated).

1.4 The Vapour Axial Deposition (VAD) Process

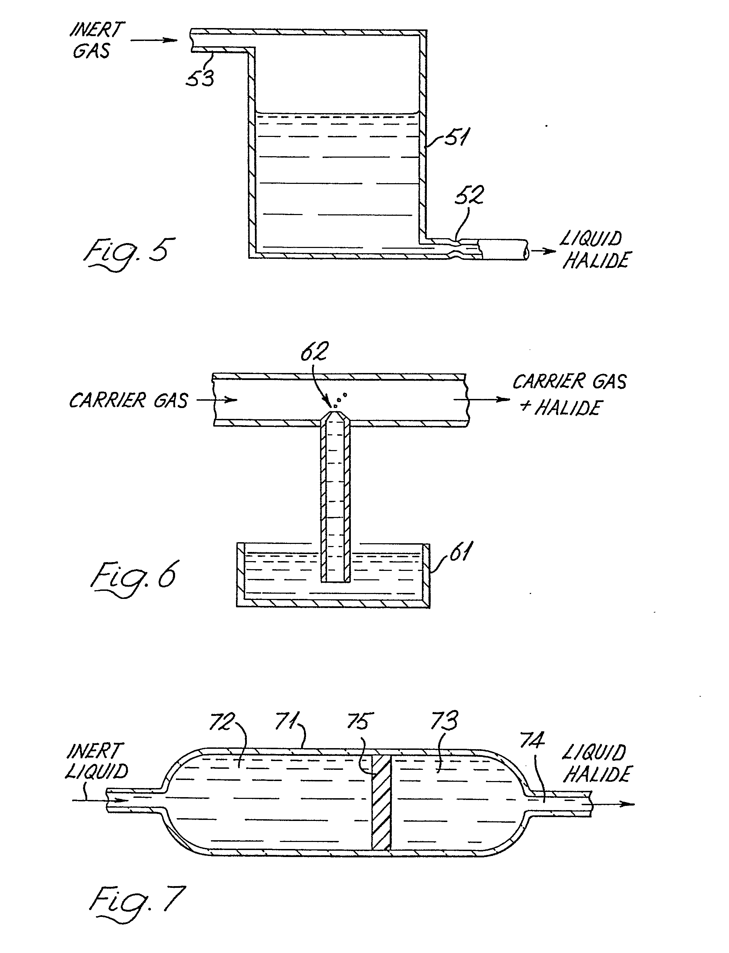

The VAD process, see T. Izawa, S. Sudo, F. Hanawa, T. Edahiro, 4th European Conference on Optical Communications, Genoa, 30-36 (1978), is also essentially a soot process; a porous preform is grown in an axial direction by the deposition of fine glass particles made by vapour-phase reaction of raw materials. As shown in Figure 3, a fused silica rod 31 is positioned so that its lower end is free and a central portion passes freely through an electric resistance heater 32. Oxy-hydrogen torches 33 are stationed below the lower end of the rod 31. The fused silica rod 31 is used as a starting seed rod. Fine glass particles 34 are synthesised from silicon tetrachloride and reactant halides by passing a mixture thereof into the oxy-hydrogen torches 33. These fine particles 34 are deposited at one end of the seed rod. In order to control the refractive index profile in the radial direction, streams of different mixtures of halides are blown into the flames, thus producing a spatial distribution of the dopant in the resulting fine glass particles. A porous preform 35 is thus grown in the axial direction and the seed rod is rotated and retracted upwards slowly as the porous preform builds up. The preform is dried as the rod is taken upwards through electric resistance heater 32, so that a transparent preform 36 results. Alternatively, drying and consolidation take place in a separate operation from the transparent preform.

2. General Requirements for a Halide Vapour Delivery System

From the above description it can be seen that a stable and accurate halide vapour delivery system is required for each method of preform fabrication. In particular, the controlled vapour delivery should be accurate to $^{+}_{-}1\%$ of flow and reproducible in the long term to $^{+}_{-}2\%$. Accuracy is especially important in the production of graded index fibres, since errors in the precisely defined parabolic profile which is required to minimise pulse dispersion can lead to decreased bandwidth in the fibre. Long-term reproducibility is important for fibre cable manufacturers who require many lengths of fibre within a fixed narrowly-defined specification to make up a cable length. Ideally the vapour flows should be programmable in steps activated by an external signal. Control by a microprocessor is desirable so as to produce fibres of graded refractive index, since accurate profiling of the refractive index is critical for the attainment of high bandwidths.

In the MCVD process, liquid delivery rates between 0.002 and 2.0 ml $min^{-1}$ are typical. For a graded refractive index profile a dynamic range of at least 100:1 is required in order to obtain a gradual variation of dopant from zero in the cladding to a maximum at the core centre.

Higher deposition rates are possible in the soot (OVPO and VAD) processes and up to 10 ml $min^{-1}$ may be delivered, with a similar dynamic range requirement in the case of the OVPO process. In addition, flows have to be maintained for several hours.

3.    Present Halide Delivery Systems

In this section the halide delivery systems currently in use in the semi-conductor and fibre optics industries are outlined.

3.1 Bubbler System

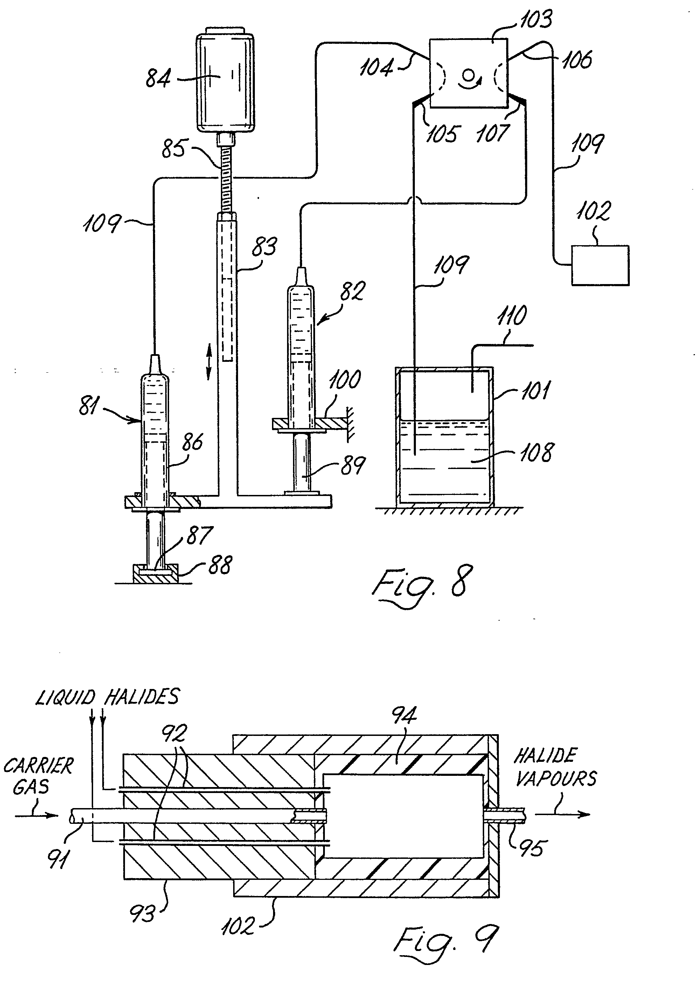

The bubbler system described by K. Chida, M. Okada, Y. Terunama and T. Edahiro, Rev. of Electrical Comm. Lab., 27, (3-4), 176 (1979), is shown in Figure 4. The liquid halides are contained in separate glass, silica or stainless steel reservoirs (bubblers) 41, usually of 500 ml or greater capacity. The liquids are typically maintained at a controlled constant temperature of $^{+}_{-}$ 0.5$^{o}$C by means of a circulator which pumps a suitable fluid round jackets 42 of the bubblers. Tubes 43 lead carrier gas into flow controllers 44, via filters 47, to the bubblers 41.

The carrier gas is usually nitrogen, argon or oxygen. To disperse it in the liquid a sintered glass frit (not shown) is provided in the base of each bubbler 41. The flow controllers 44 are thermal mass flow controllers or simple needle-valve flow controllers and meter the carrier gas flow-rate. In the case of a mass-flow controller, a DC external-command signal is compared internally with the flow rate signal to give an error voltage proportional to the difference between the desired flow rate and the actual flow rate. The actual flow-rate signal is generated as follows. Two resistance thermometers are wound adjacent to each other on the outside of a sensor tube to form two arms of a bridge circuit. The sensors are heated by an electrical current. When there is no flow in the tube, both sensors are at the same temperature so the output signal of the bridge is zero. When gas flows in the tube the upstream sensor is cooled and the heat is transferred to the downstream sensor, thus producing a signal from the bridge in proportion to the flow. A control valve in the carrier gas flow path reacts to reduce the error voltage to zero.

The liquid is bubbled out of bubblers 41 through tubes 45 and enters a manifold tube 46 where additional oxygen may be added.

The vapour flows for each halide are thus programmed by the mass-flow controllers 44 before being mixed together with a stoichiometric excess of oxygen and thence delivered to the oxidation zone, i.e. to supply one of the vapour deposition processes described above.

The accuracy of the individual vapour flows depends upon the accuracy of the carrier gas flow and the accuracy of control of the vapour pressure of the liquid halide and thus it is essential to control the temperature of the liquid accurately. For $SiCl_4$ a temperature change of $0.5^{\circ}C$ at $20^{\circ}C$ produces a 2% variation in vapour pressure. Moreover, the accuracy of the vapour flow depends

0058571

- 7 -

also on the degree to which saturation of the carrier gas flows is achieved by the bubbler. In practice, it is often found that only 80-90% saturation is achieved and this leads to vapour flow errors. Disadvantages of this system are summarised below.

## 3.1.1 Disadvantages of the Bubbler System

1. The precise vapour content of the carrier is not well defined since it varies with vapour pressure of the liquid and the saturation level. The latter can drop as the liquid level in the bubbler decreases, and also as the carrier gas flow increases.

2. The vapour content of the carrier gas is limited to the vapour pressure of the liquid at room temperature. If a higher content is desired the bubbler temperature may be raised, but unless care is taken to heat the delivery manifolds and pipework, condensation will occur.

3. In the case of low vapour-pressure liquids it is difficult to produce high vapour content in the gas stream without excessive heating of the bubbler.

4. Very accurate carrier gas flows and bubbler temperatures are required to ensure constant vapour delivery rates.

5. The continual evaporation and bubbler topping up process tends to produce an accumulation in the liquids of impurities such as $OH^-$ from the gas stream.

## 3.2 Improved Prior Art Bubbler System

Better control over the vapour saturation of the carrier gas streams can be achieved by using a condenser system on the bubbler outlet, J.B. MacChesney, Conference on Optical Fibre Communication, Washington D.C. March 6-8, 1979. The bubbler is kept at a higher temperature than the condenser. Excess vapour therefore condenses out and returns to the bubbler, leaving a fully-saturated carrier gas stream. In this way it is claimed that errors due to incomplete saturation of the vapour stream are avoided.

- 8 -

### 3.2.1. Disadvantages of the Improved Bubbler System

1. Care must be taken not to oversaturate the final gas stream with reactants entrapped as condensed mist.

2. The condenser temperature must be maintained at $\pm 0.1^{\circ}C$ to ensure a well-defined vapour pressure.

3. Other disadvantages are Nos. 2 to 5 for the basic bubbler system, see section 3.1.1 above.

### 3.3 Liquid Source Thermal Mass-Flow Controller

A more expensive and sophisticated programmable mass-flow controller is available which can be calibrated for halide-vapour flow directly. The method of operation is similar to that described above for the basic bubbler system except that the thermal conductivity of the carrier gas is measured at the bubbler inlet and compared with that of the carrier gas plus halide vapour at the outlet, the difference being proportional to the vapour content of the carrier. The error voltage (the difference between actual and commanded flow) is reduced to zero by increasing or decreasing the volume of carrier gas passing through the bubbler.

### 3.3.1 Disadvantages of the Liquid Source Thermal Mass-Flow Controller

1. Frequent calibration checks are required to maintain accuracy of vapour delivery.

2. Unless great care is taken in ensuring system integrity from small leaks of atmospheric water vapour, hydrolysis of the vapours can occur and produce blockages of small internal orifices.

3. Vapour flow-range is pre-set by the factory and cannot readily be changed.

4. The liquid halides can become contaminated by contact with the stainless steel components of the flow controller.

5. Since the vapour flow rate is controlled by varying the carrier gas flow, the <u>total</u> flow rate of carrier plus vapour varies with time. This can prove a disadvantage in applications which require a constant ratio of carrier to reactant flow rates.

### 4. The present invention

The general principle of the present invention is that the reactant is delivered at the required controlled rate as a liquid, instead of relying on its vapour pressure to control the flow rate. The liquid is delivered at a precise rate to a vaporiser where it is evaporated and added to the carrier gas stream. The method of the invention is thus more direct and easier to control accurately than the above prior methods.

The controlled rate will normally be a rate which is controlled stepwise, as a number of different rates, each of which is maintained substantially constant, preferably to an accuracy within 1%, for the duration of the time step. Of course, the time steps and differences in rate of flow between steps could be made very small, so that the rate is varied substantially continuously, e.g. over a period of several hours. Alternatively, for particular purposes, it might be desirable to produce a rate which is maintained constant during the whole period of the process.

The invention includes, in particular, a method of delivering reactant at a controlled flow rate to a reaction zone for a vapour phase deposition reaction, which comprises producing a controlled flow of vaporisable liquid reactant at a controlled rate which is controllably variable, independently of the flow rate of other fluids supplied to the reaction zone for the vapour phase deposition reaction, and introducing the reactant thus flowed as a flow of vapour or finely dispersed liquid, into the reaction zone for the vapour phase deposition reaction. Alternatively, but in accordance with the same general principle, the method can comprise producing a flow of vaporisable liquid reactant, substantially free of any carrier gas, at a controlled rate which is controllably variable, and introducing the reactant thus flowed, as a flow of vapour (which can be carried by inert or reactant gas), or finely dispersed liquid, into the reaction zone for the vapour phase deposition reaction, at a rate which depends on the controlled rate of flow of the vaporisable liquid reactant.

In one embodiment of the invention, the reactant is fed as a vapour or finely dispersed liquid into a stream of carrier gas and the mixture of carrier gas and reactant is fed to the vapour phase deposition zone. Thus, the liquid can be vaporised by heating it, e.g. within a conduit, and mixed with heated carrier gas and the mixture sent to the vapour phase deposition reaction zone. Alternatively, the liquid reactant can be sprayed into carrier gas which has been pre-heated to a temperature at which the liquid will vaporise, and the resulting mixture of carrier gas and reactant vapour introduced into the vapour phase deposition reaction zone. The carrier gas can be any which does not undergo substantial reaction with the vapour prematurely. It may be e.g. nitrogen, argon or even oxygen.

An attribute central to the invention is that the amount of liquid reactant sent to the reaction zone does not depend on the vagaries of an evaporation process. Gas emerging from a prior art bubbler system is not normally saturated with the liquid through which it has been bubbled and the uptake of liquid is not controllable accurately. The present invention does not involve the establishment of a significant reservoir of liquid: evaporation of the liquid supplied as a controlled flow is carried out rapidly, avoiding the creation of a reservoir. Thus, the rate of delivery of the reactant in question to the reaction zone is substantially independent of the rate of flow of other fluids, notably carrier gas or a gas supplied under pressure to the reaction zone, or, to put it another way, is determined substantially by the flow rate of the liquid in liquid phase flow. The flow of the reactant to the reaction zone is substantially independent of the flow rate of carrier gas or
evaporator temperature.

While the method of the invention could be carried out to
give a constant flow of liquid reactant throughout the entire
operation, it would be unusual to operate in this way for the
purposes of making optical fibres and it is therefore an
essential feature of the invention to be able to vary the
rate at will and to be able to exercise control over the
variation. A method carried out in apparatus affording no
such controllable variability is therefore not part of the
invention.

The invention further provides apparatus for carrying out
a process of the invention comprising means for producing a
controlled flow of vaporisable liquid reactant, and for
controllably varying the flow rate of the liquid reactant,
independently of the flow rate of other fluids supplied to the
reaction zone, means for vaporising the liquid reactant, means
for mixing the reactant with carrier gas and means for introducing
the mixture of vapour and carrier gas into a reaction zone for the
vapour phase deposition reaction.

Alternatively, but in accordance with the same general
principle, the apparatus can comprise means for producing
a controlled flow of vaporised liquid reactant substantially
free of any carrier gas, and for controllably varying the flow
rate of the liquid reactant, means for vaporising the liquid
reactant, means for mixing the reactant with carrier gas and
means for introducing the mixture of vapour and carrier gas
into the reaction zone at a rate which depends on the controlled
rate of flow of the vaporised liquid reactant.

In one embodiment the means for vaporising the liquid
reactant and for mixing the reactant with carrier gas comprise
a chamber into which the vapour and carrier gas are introduced
simultaneously and allowed to mix and means for heating the
carrier gas and/or the mixture to a temperature at which the liquid will vaporise. In another embodiment the means for vaporising the liquid reactant and means for mixing the reactant with carrier gas comprise a conduit for the carrier gas, inlet means in said conduit for the introduction of the liquid reactant in finely dispersed form into the carrier gas, and means for heating the carrier gas and/or the mixture to a temperature at which the liquid will vaporise.

The method of the invention can be used in conjunction with any vapour phase deposition reaction (carried out under any conventional conditions), but is primarily of interest in the oxidation or decomposition of one or more halides (including any of those previously mentioned) in the vapour phase. The reaction zone for the deposition can be a heated rotating silica tube into which the reactant is fed together with oxygen, e.g. the MCVD or PCVD process, or it can be an oxidising flame e.g. an OVPO or VAD process. An optical fibre can be made by either method, using a drawing process, e.g. as shown in stage (c) of Figure 1. The dopants used can be any of those normally used in making optical fibres and which are introduced by a vapour phase deposition reaction.

Preferably the vapour phase deposition reaction is carried out so that the rate of deposition of reaction product derived from the delivered reactant depends on the rate of delivery of the reactant to the reaction zone.

Some ways of carrying out the method of the invention are described below, with reference to Figures 5 to 9 of the accompanying drawings. Figures 5 to 7 are schematic views of apparatus for delivering the liquid at the required constant rate. Figure 8 is a diagram of one preferred such method. Figure 9 shows in detail the vaporiser of Figure 8, in schematic axial section.

4.1 Liquid-delivery Systems

The following are examples of delivery systems which can be used in the invention.

### 4.1.1 Orifice Metering System

As shown in Figure 5, the liquid contained in a suitable corrosion-resistant, high-pressure reservoir 51, is delivered through an orifice 52 at a rate controlled by pressure applied directly, or via a diaphragm, to the liquid in the reservoir. Conveniently an inert gas is passed under pressure into the reservoir through inlet pipe 53. Accurate metering is achieved by use of the linear relationship between flow-rate through the orifice and applied pressure. An alternative system utilises a constant pressure or head of liquid and a variable orifice size diameter or delivery tube length to vary the flow.

### 4.1.2 Liquid-spray System

As shown in Figure 6, the liquid is sprayed from the container 61 through a nozzle 62 as an aerosol of fine droplets. As in a conventional spray arrangement, carrier gas is directed transversely across the nozzle and this creates a low-pressure region which draws the liquid up into the gas stream where it is dispersed. An alternative but similar arrangement is to use a venturi tube through which the carrier gas flows, thus creating a low-pressure area at the constriction. The liquid-metering nozzle is placed at the neck of the venturi and liquid is drawn into the gas stream as before. In both cases the liquid delivery rate depends upon the size of the nozzle orifice, the liquid head below the nozzle and the design of the carrier gas jet or venturi. The liquid flow can be controlled by varying the carrier gas flow rate.

### 4.1.3 Indirect Pumping System

Referring to Figure 7, a non-toxic, unreactive liquid 72 is pumped by a conventional constant-volume displacement pump (usually a piston pump) at the required rate into a cylindrical chamber 71. This liquid is used to displace from the chamber an equal volume of liquid reactant 73 which then flows at the desired rate from the outlet 74 of the chamber. It is usually convenient

- 14 -

to separate the two liquids in chamber 71 by means of an inert piston or diaphragm 75 to avoid possible contamination problems.

### 4.1.4 Direct Pumping System

A constant-volume displacement pump may be used to pump the reactant directly, provided that all wetted parts are corrosion resistant. Pumps of this type are used, for example, in high-pressure liquid chromatography and are conventionally constructed of stainless steel. Typically, they have one or two reciprocating sapphire pistons, which move within bores of PTFE and use sapphire balls as non-return valves. Delivery is varied either by altering the piston stroke or its reciprocation rate. The output flow is slightly pulsatory and this can prove a disadvantage in applications where a smooth flow is mandatory. However, this can be overcome by the use of a ballast reservoir. In addition, the dynamic range of the flow tends to be limited at low flow rates by valve leakage and thus it is difficult to obtain greater than a 10:1 range by pump action alone. Lower flows can be achieved by by-passing some of the flow.

### 4.1.5 Direct Syringe-pump Systems

These are constant-volume pumps and are related to the piston pump outlined above. Syringe pumps use a conventional syringe barrel and have the plunger driven at a constant velocity by a motor and lead screw. Typically, a stroke of several cm is obtained, giving a delivery which, in the case of 50 ml syringe, need only be reversed to perform a refill stroke every hour or so. Provided that this can be timed to coincide with a halt in the deposition process, e.g. a burner return in the MCVD process, it does not prove to be a disadvantage. Syringe pumps can provide very accurate delivery rates and a wide dynamic range of flows. In addition they are constructed such that all wetted parts are PTFE or glass.

### 4.2 Vaporisation of the Liquids

The liquid, delivered by one of the above methods, is piped or sprayed into a vaporiser where it is evaporated and mixed with a carrier gas. In the case of the liquid-spray delivery method, however, the vapour-carrier gas mixture can be obtained directly from the delivery operation without a separate, subsequent, step. In any of these methods the carrier gas is fed at a volume flow and temperature such that it remains unsaturated and thus the reactant does not recondense after emerging from the vaporiser. Several methods of evaporating the liquid are now described.

4.2.1 Aerosol Evaporation

The liquid can be converted to an aerosol of fine droplets by discharge from a nozzle into a high-velocity carrier gas stream. In this case evaporation of the liquid droplets occurs directly, assisted if necessary by heating the carrier gas stream. Note that for subsequent vapour deposition by flame hydrolysis of the reactants (OVPO, VAD processes) the aerosol can be directly sprayed into the flame. Note also that the liquid delivery and vaporisation steps can be combined into one operation when a liquid spray system (section 4.1.2 above) is chosen.

4.2.2 Liquid-jet Evaporation

The liquid can be discharged from a nozzle as a jet or spray and directed on to a heated plate, made for example of a ceramic frit or ground glass. It might be preferable to warm the plate only slightly to a few degrees above room temperature, in order not to volatilise impurities of low volatility present in the liquid. The vapour is then swept away by the carrier gas. Again, in the case of the OVPO and VAD processes it can be sprayed directly into a flame. In the MCVD process it is envisaged that the aerosol spray of 4.2.1 or the jet spray of 4.2.2 can be introduced directly into the tube.

5. Preferred Embodiment

The following method has been developed and used successfully for fibre production by the MCVD method and is currently the preferred method of the invention.

5.1 Liquid Delivery

Referring to Figure 8, a dual syringe pump, consisting of a gas-tight glass first syringe 81 and a gas-tight second syringe 82, is mounted on a carriage 83. The carriage 83 is drivably connected to a stepper-motor 84 by means of a lead screw 85. The first syringe 81 is clamped to the carriage 83 by its barrel 86.

while its plunger 87 is retained within a fixed mounting block 88, so that the barrel is movable with respect to the stationary plunger. The second syringe 82 is clamped to carriage 83 by its plunger 89, while its barrel is retained by a fixed mounting block 100, so that the plunger is movable with respect to the stationary barrel. Thus, the syringe plungers are arranged to operate in opposition to one another, whereby one syringe refills while the other discharges. The syringe pump is connected to a liquid reservoir 101 constructed of glass and to a vaporiser 102 via a four-way valve 103. The valve 103 has four ports 104, 105, 106, 107, connectable in pairs. The drawing shows them in communication with, respectively, the first syringe 81, reservoir 101, vaporiser 102 and second syringe 82. Connections are via PTFE tubing 109. The reservoir 101 contains liquid halides 108, as required for the optical fibre. It can be re-filled via pipe 110.

The apparatus is operated as follows. Starting from the positions of the valve 103 shown, barrel 86 of syringe 81 is moved upwards by carriage 83, causing the syringe to refill with liquid from reservoir 101 via ports 105, 104 in the valve. Simultaneously, plunger 89 of syringe 82 is moved upwards by carriage 83, causing this syringe to discharge its liquid into vaporiser 102 via ports 107, 106 in valve 103. When the carriage has completed its upward movement the valve is actuated through a right angle, so that ports 105, 107 and 104, 106 are in communication. Simultaneously, the carriage is moved downwards. Syringe 81 discharges liquid via ports 104, 106 into vaporiser 102, while syringe 82 fills with liquid from reservoir 101 via ports 105, 107. At the end of each "stroke" (one downward or upward movement of the carriage), the valve is actuated to continue the cycle.

Since each stroke can be arranged to take 10 minutes or more to complete, the change-over can be timed to coincide with the reversal of the burner in the MCVD or OVPO processes. The slight interruption of flow which occurs at change-over, particularly if some backlash occurs, can be a disadvantage in a continuous process such as the VAD technique. In this case the "dead time" between strokes can be made much shorter by a modification. In the modification two independently driven syringes are used and are reversed at slightly different times. In this case the filling syringe is reversed first, so that it pumps at full delivery rate back into the reservoir. When the discharging syringe is reversed and the valve actuated, the flow to the reservoir is immediately diverted to the discharge and only a very brief interruption in flow occurs.

The pump delivery rate can be programmed over a very wide range not only by changing the step rate of the motor but also by using larger or smaller syringes. A typical configuration can be designed to have a minimum step rate of 10 steps/sec, to ensure a virtually pulse-free delivery, and a maximum rate of 10,000 steps/ sec using a 400 steps/rev motor. This can be translated to flow rate by a variety of gear box ratios, lead screw pitches and syringe volumes, such that flows from 0.001 ml/min to 1000 ml/min can be envisaged. A 96 step/rev motor, a 100:1 gearbox, a lead screw with 40 turns/in pitch and a 10 ml syringe have been used successfully. This combination gives a minimum flow of 0.0065 ml/min at 10 steps/sec and a maximum flow of 1.3 ml/min at 2000 steps/sec, i.e. a dynamic range of 200:1.

5.2 Vaporiser System

Referring to Figure 9, the vaporiser 102 is a heated block containing ceramic multibore-tubes (typically 60 mm long, 2 mm outside diameter and 0.7 mm bore) or any similar inert, heat-resistant tube. A central tube 91 admits carrier gas and two or more ceramic tubes 92 the halides. The tubes are housed within a metal block 93 which is heated. The tubes lead into a manifold chamber 94 made of PTFE, of generally cylindrical shape, having an outlet 95 for the mixture of halide vapour and carrier gas.

Fine-bore ceramic tube was found to perform better than glass because it provided a large surface area and, being rough, more nucleation sites. The latter are important in preventing 'bumping'

- 18 -

when the liquid boils. The tubing is clamped in the metal block 93 and heated to a temperature above the boiling point of the liquid to be vaporised. Care must be taken not to overheat the tube, since this would cause premature vaporisation of the liquid in the connecting tube. Spurting or bumping then occurs owing to the expansion associated with vaporisation, resulting in erratic delivery.

The different vapours required are emitted from the separate ceramic tubes contained within the heated metal block, and are introduced simultaneously with the carrier gas into the manifold chamber 94. Sufficient carrier gas flow must be used to ensure that the gas does not become saturated with the vapours and recondensation occur. The vapour and carrier gas mixture is then piped to the deposition system. Any other means could be used to heat the carrier gas and/or the mixture to a temperature at which the halide liquid will vaporise.

6.    Advantages of the Preferred Embodiment

(a) Compact. A liquid delivery system is in general more compact than conventional systems. All pipework, valves and junctions can be made in flexible PTFE capillary tubing, fittings for which are readily available. Thus a liquid delivery system for each of 5 or more reactants can be contained in a small inert-gas cabinet which safely encloses all corrosive liquids. The electronics and drive mechanism for the syringes are external to the cabinet, thus preventing corrosion in the event of leaks.

(b) Safe, Pure and Inert. All components wetted by the reactant liquids and vapours are fabricated from PTFE, glass or ceramics and thus no chemical attack or contamination of the liquids can occur. The ultra-pure liquids are supplied in ampoules or bottles and the syringe pumping system is designed such that it can be used to safely pump liquid from the shipping container to the internal reservoir, after which the liquid is securely enclosed.

(c) <u>Accurate and Programmable</u>. The syringe plunger is precisely controlled by the stepper motor, the electronic drive for which is highly accurate. Thus a stable, reproducible, linear and easily-programmable liquid delivery-rate is obtained. Commercial syringe pumps without the benefit of stepper motor drives are claimed to have a delivery accuracy to within 1%. Moreover, with a stepper-motor the calibration is absolute and cannot drift; it depends only on the syringe size and mechanical gearing. No problems of lack of saturation are experienced as in bubbler systems. Furthermore, the system has no delicate components or small metering orifices which may clog.

(d) <u>Large Dynamic Range</u>. The stepper-motor drive can have a dynamic range (range of speeds over which the speed is controllable) of 1000:1 (assuming a minimum step rate of 10 steps/sec) and this can be doubled by half-step driving. By the simple expedient of changing syringes the delivery range can be changed to suit different processes and various dopants.

(e) 'Simple Carrier Gas Metering. The all-important rate of flow of reactants to the deposition zone is unaffected by the flow of carrier gas, since the syringe pump delivers a constant volume (and hence constant mass) of reactants. The deposition process depends primarily on the rate of flow of reactants and thus the liquid-pumping technique is ideally suited. The carrier gas flow can simply be regulated to an approximate flow level.

(f) <u>Short Response Time</u>. Since with careful design, the liquid dead-volume contained in the system pipework can be kept small, flow changes can be made almost instantaneously.

(g) <u>Very High Delivery Rates</u>. Up to 10 ml/min or more can be achieved by simply employing a large syringe. No difficulties are experienced with lack of saturation, as in bubbler systems.

(h) <u>Minimum Carrier Gas Dilution</u>. In the case of bubbler or mass flow controller systems, sufficient carrier gas to pick up each of the reactants separately must be provided. In the liquid delivery method of the invention, only sufficient carrier gas to prevent saturation occurring for the total vapour content is required. Thus considerably less carrier gas is required and this is often an advantage, since the gas tends to dilute the deposition reaction. Moreover, in flame deposition processes such as OVPO and VAD the liquid can be sprayed directly into the oxidising flame without the need for a carrier gas.

CLAIMS

1. A method of delivering reactant at controlled flow rate to a reaction zone for a vapour phase deposition reaction, which comprises producing a flow of vaporisable liquid reactant, at a controlled rate which is controllably variable, independently of the flow of other fluids supplied to the reaction zone for the vapour phase deposition reaction, and introducing the reactant thus flowed, as a flow of vapour or finely dispersed liquid, into the reaction zone for the vapour phase deposition reaction.

2. A method of delivering reactant at a controlled flow rate to a reaction zone for a vapour phase deposition reaction, which comprises producing a flow of vaporisable liquid reactant, substantially free of any carrier gas, at a controlled rate which is controllably variable, and introducing the reactant thus flowed, as a flow of vapour or finely dispersed liquid, into the reaction zone for the vapour phase deposition reaction, at a rate which depends on the controlled rate of flow of the vaporisable liquid reactant.

3. A method according to Claim 1 or 2 wherein the reactant is introduced into the reaction zone by feeding it as a vapour or finely dispersed liquid into a stream of carrier gas and feeding the mixture of carrier gas and reactant to the reaction zone.

4. A method according to Claim 3 wherein the liquid is introduced into the reaction zone by heating it within a conduit to evaporate it, mixing the resultant vapour with heated carrier gas and feeding the mixture of carrier gas and reactant vapour to the reaction zone.

5. A method according to Claim 3 wherein the reactant is introduced into the reaction zone by spraying it as a liquid into carrier gas which has been pre-heated to a temperature at which the liquid will vaporise, and feeding the resulting mixture of carrier gas and reactant vapour into the reaction zone.

6. A method according to Claim 3, 4 or 5 wherein the mixture of carrier gas and reactant is introduced, together with oxygen, into a heated, rotating silica tube.

- 22 -

7.  A method according to Claim 1 or 2 wherein the reactant is introduced into the reaction zone by feeding it as a finely dispersed liquid into an oxidising flame.

8.  A method according to any preceding claim wherein a controlled mass flow of a liquid reactant is produced by metering a controlled volume of the liquid from a positive displacement pump.

9.  A method of carrying out a vapour phase deposition reaction, which comprises delivering reactant by a method claimed in any preceding claim to a reaction zone for a vapour phase deposition reaction and carrying out a vapour phase deposition reaction in said zone.

10.  A method according to Claim 9 wherein the deposition reaction is carried out so that the rate of deposition of reaction product derived from the delivered reactant depends on the rate of delivery of the reactant to the reaction zone.

11.  A method according to Claim 9 or 10 wherein the reactant comprises one or more halides and the vapour phase deposition reaction comprises an oxidation to produce one or more oxides.

12.  A method according to Claim 11 wherein the reactant is silicon tetrachloride together with one or more dopant halides and a coating of doped silica is deposited within a tube or on a cylindrical substrate to produce an optical fibre.

13.  A method according to Claim 11 wherein the reactant comprises silicon tetrachloride and a liquid fluorine-containing compound decomposable to provide fluorine as a dopant for silica and the vapour phase deposition reaction comprises oxidation of the silicon tetrachloride and decomposition of the fluorine-containing compound to dope the resultant silica.

14.  Apparatus for carrying out a method claimed in Claim 1, comprising means for producing a controlled flow of vaporisable liquid reactant, and for controllably varying the flow rate of the liquid reactant independently of the flow rate of other fluids supplied to the reaction zone for the vapour phase deposition reaction, means for vaporising the liquid reactant, means for mixing the reactant with carrier gas and means for introducing the mixture of vapour and carrier gas into the reaction zone for the vapour phase deposition reaction.

15. Apparatus for carrying out a method claimed in Claim 2 comprising means for producing a controlled flow of vaporisable liquid reactant substantially free of carrier gas and for controllably varying the flow rate of liquid reactant, means for vaporising the liquid reactant, means for mixing the reactant with carrier gas and means for introducing the mixture of vapour and carrier gas at a rate which depends on the controlled rate of flow of the vaporisable liquid reactant.

16. Apparatus according to Claim 14 or 15 wherein the means for producing a controlled flow of liquid reactant comprises a programmable controller for producing a substantially continuously varying flow rate.

17. Apparatus according to Claim 14 or 15 wherein the means for vaporising the liquid reactant and for mixing the reactant with carrier gas comprise a chamber into which the vapour and carrier gas are introduced simultaneously and allowed to mix and means for heating the carrier gas and/or the mixture to a temperature at which the liquid will vaporise.

18. Apparatus according to Claim 14 or 15 wherein the means for vaporising the liquid reactant and means for mixing the reactant with carrier gas comprise a conduit for the carrier gas, inlet means in said conduit for the introduction of the liquid reactant in finely dispersed form into the carrier gas, and means for heating the carrier gas and/or the mixture to a temperature at which the liquid will vaporise.

19. Apparatus according to Claim 14 substantially as hereinbefore described with reference to and as illustrated by Figure 5, 6, 7, 8 or 9 of the accompanying drawings, optionally in conjunction with any one of Figures 1 to 3 of the accompanying drawings.

**0058571**

1/4

SiCl$_4$ + O$_2$ + DOPANT VAPOURS

EXHAUST 13

Fig. 1a

Fig. 1b

Fig. 1c

Fig. 2

FUEL

SiCl$_4$ + O$_2$ + DOPANT VAPOURS

Fig. 3a

Fig. 3b

Fig. 3c

Fig. 4

INERT GAS →

53

51

52

LIQUID HALIDE

*Fig. 5*

62

CARRIER GAS →

CARRIER GAS + HALIDE →

61

*Fig. 6*

72  71  75  73  74

INERT LIQUID →

LIQUID HALIDE →

*Fig. 7*

Fig. 8

LIQUID HALIDES

CARRIER GAS

HALIDE VAPOURS

Fig. 9

| | EUROPEAN SEARCH REPORT | Application number |
|---|---|---|
| European Patent Office | | EP 82 30 0807 |

## DOCUMENTS CONSIDERED TO BE RELEVANT

| Category | Citation of document with indication, where appropriate, of relevant passages | Relevant to claim |
|---|---|---|
| XY | GB - A - 2 015 991 (CORNING GLASS WORKS)<br><br>* Figure; page 2, lines 24-64; page 3, lines 18-126 * | 1-19 |
| Y | US - A - 3 453 412 (R. WALWARK)<br>* Claim 1; figure 2 * | 1,3,4,<br>7-9,<br>11,17 |

**CLASSIFICATION OF THE APPLICATION (Int. Cl. 3)**

C 23 C 11/00
C 03 B 7/025

**TECHNICAL FIELDS SEARCHED (Int.Cl. 3)**

C 23 C 11/00
C 03 B 37/025

**CATEGORY OF CITED DOCUMENTS**

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| X | The present search report has been drawn up for all claims | | |
|---|---|---|---|
| Place of search<br>The Hague | Date of completion of the search<br>06-05-1982 | Examiner<br>BOUTRUCHE | |

EPO Form 1503.1 06.78